(19) Europäisches Patentamt
European Patent Office
Office européen des brevets

(11) Publication number: 0 512 401 A2

(12) **EUROPEAN PATENT APPLICATION**

(21) Application number: **92107329.2**

(51) Int. Cl.[5]: **H01B 3/30**

(22) Date of filing: **29.04.92**

(30) Priority: **03.05.91 US 695355**

(43) Date of publication of application: **11.11.92 Bulletin 92/46**

(84) Designated Contracting States: **DE FR GB**

(71) Applicant: **International Business Machines Corporation**
**Old Orchard Road**
**Armonk, N.Y. 10504(US)**

(72) Inventor: **Mukherjee, Shyama P.**
**45 Mountain Pass Road**
**Hopewell Junction, N.Y. 12533(US)**
Inventor: **Wang, David W.**
**800 Overbrook Road**
**Vestal, N.Y. 13850(US)**

(74) Representative: **Mönig, Anton, Dipl.-Ing.**
**IBM Deutschland GmbH Patentwesen und Urheberrecht Schönaicher Strasse 220**
**W-7030 Böblingen(DE)**

(54) **Low dielectric constant composite laminates filled with molecularly porous aerogels.**

(57) A low dielectric constant, controlled coefficient of thermal expansion, low cost material which includes uniformly distributed aerogel microspheres having voids in molecular dimension (at nanoscale) is prepared by extrusion and standard impregnation and lamination techniques. The aerogel microspheres are prepared by sol-gel technique and supercritical drying of the sol-gel particulates. Laminates including this material can be drilled cleanly for through holes and can be used as a substrate for surface mounted devices. Also, these low dielectric aerogel microsphere containing composite resins, when the resin is a photosensitive polymer, can be applied to substrate surfaces such as ceramic or multilayer ceramic substrates and photolithographically processed.

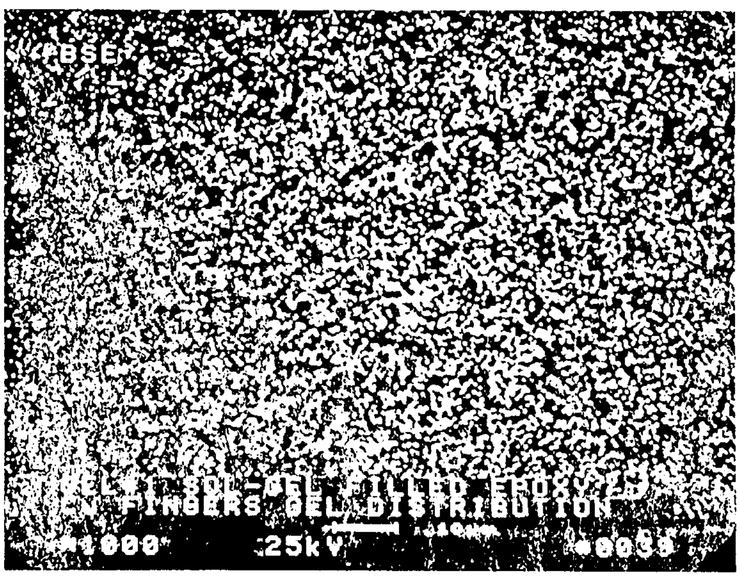


FIG. 11

EP 0 512 401 A2

This invention relates to a dielectric material for use in electronic applications where low dielectric constant is important, and a process for making same.

More particularly, this invention relates to a material useful in a printed circuit board (PCB) structure, which may include more than one conductive layer and may incorporate electrical interconnections called blind vias, or through holes, between two or more conductive layers. This invention is also well suited for use as a substrate material for surface mounted integrated circuits.

Most particularly, this invention relates to a material and printed circuit board comprised thereof which includes a polymer matrix composite material having sol-gel derived glassy microspheres with nanoscale porosity. In other words, the dispersed phase comprises molecularly porous aerogel microspheres. The aerogel microspheres are derived from the spherical sol-gel particulates after supercritical drying. The microspheres define voids, the sizes of which are at molecular levels and can be tailored by varying the gel processing chemistry, such as using a catalyst, and process techniques. The presence of molecularly porous gel particulates/microspheres imparts a uniform, low dielectric constant and improved thermal stability and thermal expansion to the composite thus produced. The term "sol-gel particulates" includes as one particular type, monosize microspheres.

The invention is particularly suitable for use in VLSI (Very Large Scale Integrated) structures.

In addition, this invention relates to a filler material and process for making a filler material suitable for use as the dispersed phase in a high performance polymer matrix.

Alternatively, properties of the filled polymer, such as excellent heat transfer, low alpha particle emission and controlled coefficient of thermal expansion and flowability make it suitable also as an encapsulant between the surface mounted chip and the printed circuit board in the flip chip, i.e. C4 (controlled collapse chip connection) technology.

The necessity of developing ever-increasingly high speed computers has led to the exploration of new materials which would extend the electrical and thermal performance limits of the presently available technology. For high speed applications it is necessary to have extremely dense conductor circuitry patterning on low dielectric constant (Er) insulating material. Signal transmission delay time is proportional to the square root of the dielectric constant of the dielectric material used, as expressed by

$$T_D = E_r \sqrt{\cdot D}/C$$

where $T_D$ is the transmission delay time, Er is the dielectric constant of the material, C is the velocity of light ($3x10^8$ m/sec) and D is the length of the signal path. The equation indicates that the lower the dielectric constant, the faster the signal propagation.

Lower Er also reduces crosstalk between adjacent circuit lines. Ideally, the value of the Er should approach as a limit 1.0, the value in a vacuum. For new computer systems to become faster, system cycle times must become shorter. With the next generation of computers, the delay time contributed by signal travel within the PCB's will become very significant, hence the need for lower Er laminate materials. Future products are expected to require overall Er's of 3.0 or below. Such low Er's are impossible to obtain without new materials, since the Er's of conventional FR4 epoxy resin and common fiber glass reinforcement are typically on the order of 4 and 6 respectively. The effective Er of such composite materials can usually be approximated by a simple weighted average of the Er of each individual component and its volume fraction contained in the composite. For example, prepreg laminates within conventional circuit boards are traditionally made up of a base reinforcing glass fabric impregnated with a resin. Epoxy/glass laminates, used in current products, typically contain about 40% by weight fiber glass and 60% by weight epoxy resin, and typically have an Er of approximately 4.2. Such a relatively high Er causes electrical pulses (signals) present in the highly dense adjacent signal circuit lines in future products to propagate less rapidly, resulting in excessive signal delay time.

Pure fluoropolymers such as polytetrafluoroethylene (PTFE), have Er's of approximately 2.1. However, using such a material alone in construction of a circuit board laminate is impractical, due to its generally poor mechanical properties and chemical inertness. One alternative is to use fluoropolymer as one of the components of a composite laminate material, such as the fiber in the reinforcing cloth. An example of this is the treated PTFE fabric prepreg produced by W. L. Gore and Associates, of Newark, Delaware. When this type of fabric is used to replace fiber glass in conventional epoxy/glass laminates, the Er drops to 2.8. However, use of this fabric presents certain disadvantages. Because of the comparatively low modulus of pure PTFE, thin laminates made with these materials are not very rigid, and require special handling. Also when laminates incorporating PTFE fabric are drilled, uncut PTFE fibers tend to protrude into the drilled holes and are difficult to remove. In order to obtain good plating adhesion, exposed PTFE surfaces are commonly treated using either an expensive chemical requiring special handling in a nitrogen atmosphere

or by plasma processing, which must penetrate high aspect ratio through holes. Certainly one of the biggest disadvantages of PTFE fabric laminate is cost, not only the higher cost due to additional processing requirements and equipment modification, but also the considerable cost of purchasing the prepreg material itself.

Another property which is considered in predicting the performance of a laminated dielectric material is the coefficient of thermal expansion (CTE). It is desirable to closely match the coefficients of thermal expansion in the X and the Y directions of the dielectric material to that of the adjacent copper, which is 17 parts per million (ppm), contained in the PCB in order to prevent cracking of soldered joints linking the PCB to a surface mounted device. The X and Y direction CTE's are normally controlled by the glass fibers within the matrix. However, these fibers do not control Z direction CTE. Z direction CTE must also be controlled in order to prevent cracking of copper plated through holes during heat cycling. Heat cycling occurs as heat is applied followed by cooling when preparing or reworking solder connections, and in other manufacturing processes, and is generated during current flow when the finished board is in operation. One way to modify the CTE of a polymer is by the use of fillers such as quartz and silica particles. Fillers may be linked to the matrix polymer to which they are added by the use of a coupling agent, often a silane based organic compound. The coupling agent improves the bonding between the filler and the polymer, minimizing the total interfacial area, i.e., the area of contact between the filler particle and the polymer of the matrix, which also improves both electrical and mechanical performance.

The CTE of a dielectric material changes markedly when an inflection point called the glass transition temperature (Tg), i.e. softening point, is reached. Since the expansion rate of the dielectric material increases considerably when the Tg is reached, it is desirable for a dielectric material to have a high Tg well above the temperature the material will see in the lifetime of the device, in order to minimize stresses. Epoxy novolac-based dielectric materials, for example, are considered to have a relatively high Tg, generally 150 degrees C or greater. Other characteristics associated with high Tg often include low moisture absorption and chemical inertness. It should be noted that the presence of fillers in a polymer increases the softening point (Tg) of the polymer. In other words, the dimensional stability at higher temperature (still below Tg) improves in the presence of a filler. The presence of a filler enhances the thermal conductivity of the polymer layer and thus, the heat dissipation in the dielectric layer will be enhanced. A discussion of Tg is found on pp. 555-560 of Microelectronics Packaging Handbook, Tummala et al, Ed., published by Van Nostrand Reinhold, New York, 1989, which is incorporated herein by reference.

It is therefore an object of the invention to provide a low dielectric prepreg material suitable for use in laminated printed circuit boards, optionally in conjunction with surface mounted devices such as in direct chip attach (DCA).

The invention provides a filled low dielectric material having controlled low X, Y and Z direction CTE, high Tg, low Er and excellent workability.

A dielectric material comprising fluoropolymer resin or other polymer, such as liquid crystalline polymer, and microspheres having a median diameter in the range of about 10 nm to about 1000 nm (about 100 Angstroms to about 10,000 Angstroms) are provided; the diameter of voids in these microspheres is in the range of about 2 nm to about 50 nm (about 20 Angstroms to about 500 Angstroms). Moreover, this type of material can be manufactured and processed using conventional impregnation, extrusion and lamination techniques and equipment.

Furthermore a method of making a microporous silica filler uniformly dispersed in a polymer matrix by sol-gel technique, explained further hereinafter, and a prepreg material comprised thereof is provided.

Optionally, these fillers can be dispersed in photo-sensitive polymer, such as photosensitive epoxy resin, and so dispersed can be applied to the outer surfaces of a ceramic carrier, circuit board or layer thereof, or on a similar substrate intended to be circuitized to produce a pattern for metallization, photopatterned and cured by conventional lithographic techniques. This procedure is possible only because of the extremely fine particle size of the aerogel. Because of the nanoscale porosity and the nature of pore geometry, the aerogel is transparent to a large part of the spectrum in the visible and ultraviolet region. The presence of the filler improves the mechanical properties and reduces the coefficient of thermal expansion (CTE) of the laminate.

These and other objects of the present invention are achieved in an electronic packaging structure comprising a circuitized substrate, such as a printed circuit board, comprised of at least one layer of metal clad, filled dielectric prepreg material. Optionally, the packaging structure may include a full panel flexible film chip carrier having at least one semiconductor chip, or other such electronic device, mounted thereon at bonding sites.

The prepreg material of the circuitized substrate includes, preferably, a fluoropolymer low CTE liquid crystalline polymer fabric or film reinforced halogenated epoxy, fluoropolymer resin or other polymer resin

listed in Table 1, filled with monosize gel-derived glassy aerogel microspheres defining a porosity in molecular level, in nanoscale (i.e. approximately equal to 3 nm (30 Angstroms). The porosity in the gel microsphere is retained and controlled by the supercritical drying of wet sol-gel particulates. Aerogels are sol-gel derived, super-critically dried materials with densities between about 50 to about 500 kg/$m^3$, corresponding to porosities of about 98% to about 80%. The pore structure in the gel microsphere extends from a range of about 1 nm (10 Angstroms) to about 100 nm (1,000 Angstroms).

The size and volume fraction of the porosity or voids in the microsphere is controlled by the sol-gel synthesis chemistry, the drying technique and the thermal history of the sol-gel microspheres. It is the supercritical drying of the microsphere which is a unique approach for maintaining the original nanoscale porosity of the wet gel in very high volume fractions. Conventional drying causes the collapse of the pores or voids generated during the polymerization process and the trapping of solvents and water in the voids. It is extremely difficult to eliminate the residual organics and water from the conventionally dried particulates, and the presence of the organics and water is not acceptable.

The composite resin, having monosize molecularly porous microspheres prepared by the sol-gel technique, can be used to manufacture PCB laminates by the conventional laminating techniques, thereby being suitable for low cost manufacture on existing equipment. The supercritical drying of sol-gel monoliths has been reported, but nothing is known in the art on the supercritical drying of monosized sol-gel particulates and their subsequent use in the fabrication of laminates or polymer matrix composites for the electronic packaging application. The filler of the present invention has an average diameter of about three orders of magnitude smaller than commercially available hollow microsphere filler, which makes it possible to incorporate more air into the dielectric and more nearly approach the value of the ideal dielectric constant. Moreover, these aerogel microspheres are not completely hollow. They have a skeletal silica network, as a result the mechanical properties of these microspheres are much superior to the mechanical properties of completely hollow, relatively large microspheres with one large pore, such as a microballoon.

The filler material of the present invention is composed of pure inorganic phase silicate or mixed inorganic-organic silicate aerogels, (i.e. super-critically dried gels) as the dispersed phase in a low dielectric constant polymer matrix to form a composite. The composite thus composed may be in either in the form of a layer thin film or in the form of a thick laminated substrate. The size and volume fraction of the incorporated voids in the microsphere filler can be controlled by tailoring the chemistry of gel preparation and the thermal treatment of the supercritically dried gels.

- Fig. 1a is a Scanning Electron Micrograph (SEM) of a photopatterned epoxy-aerogel composite film at 100x magnification.
- Fig. 1b is an SEM of a photopatterned epoxy-quartz particulate composite film showing surface roughness due to the size of the particulates and poor coupling at the particulate/resin interface.
- Fig. 2 is a typical representation of monosized aerogel microsphere particulates dispersed in an epoxy resin. The diameter of each is about 200 nm.
- Fig. 3 is a transmission micrograph of silica aerogel showing the voids inside the microspheres.
- Fig. 4 is an SEM of silica aerogel particulates dispersed in the epoxy resin.
- Fig. 5 is an SEM of conventional quartz powder dispersed in the epoxy resin shown at a magnification of 1000x.
- Figs. 6 and 7 are SEMs of a photopatterned composite comprising conventional quartz powder (10% Novacite) dispersed in the epoxy resin.
- Figs. 8 and 9 are SEMs of a photopatterned composite comprising silica aerogel particulates dispersed in the epoxy resin.
- Fig. 10 is a graph of a typical process silica gel sintering.
- Fig. 11 is an SEM of a composite comprising a high volume fraction of dispersed aerogel particulates dispersed in the epoxy resin.
- Fig. 12 is an SEM of a composite comprising a commercial quartz powder dispersed in the epoxy resin in the same weight fraction as are the aerogel particulates.
- Fig. 13 is an SEM of 10% by weight silica aerogel particulates dispersed in photosensitive epoxy resin.
- Fig. 14 is an SEM of 10% by weight commercial quartz particulates dispersed in photosensitive resin.

Table 1 shows the dielectric constants for a number of polymers of potential use as matrices in the present invention.

Table 2 shows the dielectric constant for the $Si0_2$ aerogel at various densities.

Table 3 shows the effect of distillation on the purity of ethyl silicate.

Table 4 shows the dielectric constant of $Si0_2$ aerogel as a function of volume fraction of voids.

Table 5 shows the estimated dielectric constants of polymer matrix composites as a function of varying volume fraction of voids.

Conventional thermoplastic fluoropolymer resin materials have an inherently low dielectric constant. However, the thermoplastic nature and the resulting poor thermal dimensional stability normally substantially prevent the use of fluoropolymers in laminates. While it is known that the presence of certain types of filler particles can improve the thermal behavior of dielectric resin materials, not all fillers have a beneficial effect on the dielectric constant. Thermosetting dielectric resin materials present many advantages over thermoplastic fluoropolymers, including better dimensional stability and processability. However, their dielectric constant is often higher. If it were possible to incorporate air as a uniformly distributed filler of reproducible size and shape into a conventionally processable resin material, the dielectric constant of the resulting material would be reduced rather than raised, since the dielectric constant of air is closest to that of vacuum. The present invention offers a novel approach to introducing a large void capacity in the microspheres. The fabrication of submicron size aerogel monosize microspheres having nanoscale voids opens up the route of introducing the maximum amount of air, which has the dielectric constant closest to ideal, into the glassy or polymeric microspheres with a uniform distribution of voids and without deteriorating the mechanical properties. A typical representation of monosized aerogel microsphere particulates is shown in Fig. 2.

Although it has been recognized for approximately ten years that microspheres might, by incorporating air, lower the dielectric constant of a dielectric laminate, such materials are still not commercially available.

Microsphere size is also important relative to general reliability. Future circuit board designs will involve lower impedances. Lower impedances require thinner dielectric layers. Obviously, thinner dielectric layers require a smaller size of filler particle in order to prevent shorting through the thin dielectric layer in case of breakage of even one hollow microsphere. When smaller microspheres are used, reliability is improved. Improvement of reliability is based on the following facts. The microspheres of the invention are extremely small (submicron size), the voids being on a molecular level. Moreover, the thermal treatment to which the microspheres are subjected induce sintering and densification which improves the mechanical properties. It is therefore difficult to break or damage the microspheres during fabrication and lamination process steps.

It should be noted that the microspheres of the present invention are not perfectly hollow spheres, they are spheres made with a matrix of silica/silicate phase having voids in the size ranging from about 1 nm to about 10 nm (about 10 Angstroms to about 100 Angstroms). The size of the spheres themselves can be made monosize and the size can range from about about 10 nm to about 1000 nm (about 100 Angstroms to about 10,000 Angstroms). A transmission electron micrograph (TEM) of silica aerogel particulates is shown in Fig. 3. Because of the nanoscale porosity and the silica skeletons within the nanoscale pores, the mechanical properties, particularly the stiffness and compressive strength of the composite which incorporates them is higher than a composite which incorporates large pore microspheres.

The removal of the hydroxyl groups to the several ppm level is achieved by following the schedule given below. Thus the influence of hydroxyl content on electrical properties such as dielectric loss tangent, an indication of the loss of dielectric function due to the presence of moisture borne impurities can be eliminated. Moreover, because of the absence of ionic and metallic impurities due to distillation eliminates the contribution to the dielectric loss tangent by those impurities.

Procedure for Removal of hydroxyl group:

Room temperature to 300 degrees C, in air or oxygen, heating at a rate of 300 degrees C/hr;

Holding at 300 degrees C for about 2 to about 5 hrs in dry air or oxygen;

Heating from 300 degrees C to 600 degrees C in air or oxygen at a heating rate of 300 degrees C/hr;

Holding at 600 degrees C for about 2 to about 4 hrs in a dry air or oxygen flowing environment;

The dehydration or removal of residual $OH^-$ groups is done by flowing $Cl_2$/Ar or He for a short time (approximately equal to 30 min.) in the temperature range of about 600 degrees C to about 800 degrees C. The $Cl_2$ treatment is needed in order to get only a few ppm or less $OH^-$ content.

The holding time at a particular temperature and the rate of heating to the holding temperature are the parameters which control the desired volume fraction of voids, the size of the voids and the physical nature of the voids or pores. The process described above results in the formation of interconnecting pores. Conversion of interconnecting pores to closed pores is achieved by "flash" sintering process which involves a rapid heating after the removal of hydroxyl groups to a temperature in the range of about 800 degrees C to about 1200 degrees C and holding for a short time, such as several minutes (e.g., about 5 to about 15 minutes). This rapid heating causes densification, i.e. sintering, at the surface of the microsphere without complete densification of the body, i.e., without elimination of the voids. Consequently, a high volume

fraction of the pores inside the sphere are manufactured with surface sintering or with a collapsing of pores at the surface. Fig. 10 shows the densification process of aerogel monoliths based on which the sintering of aerogel powders was developed. A slight coalescing of the particulates in the powder occurs on thermal treatment at higher temperatures. The particulates are subsequently ground, preferably by air jet milling to avoid contamination.

Microsphere size and size distribution also has an important influence on packing factor, particularly when very thin dielectric layers are to be made. Generally speaking, packing factor is the volume percent occupied by a filler. The formulations of the examples to follow call for microporous silica-gel particle or fiber content of approximately 45% by volume. Size and size distribution must allow sufficient packing within the thinnest required laminate layer thickness.

Considering all the previously mentioned effects of microsphere diameter, acceptable microspheres must exhibit a maximum diameter of no more than about 1 $\mu$m (10,000 Angstroms), but the smaller the better.

Microspheres of the present invention range in size from about 0.1 $\mu$m to 0.5 $\mu$m; the size of the voids is in the range of about 1 nm to about 20 nm (about 10 Angstroms to about 200 Angstroms).

Scanning Electron Micrographs (SEMs) typical of the monosize aerogel and the distribution of aerogel particulates in a photosensitive epoxy matrix thin film are shown in Fig. 4. The distribution of the conventional quartz powders in the same epoxy matrix is shown in Fig. 5. The photopatterning of the resin mixture was done by conventional lithography techniques. After photopatterning and developing, the conventional mixture of the quartz particles shows the pull-out of the quartz particulates (see Figs. 6 and 7), whereas the aerogel particulates remain strongly bonded with the epoxy matrix (see Figs. 8 and 9).

Ionic contamination must also be considered. Ionic contamination can result from using either ion contaminated resin or from ions leaching from the glass fabric or microsphere shell walls. The presence of ions in most electrical grade resins is carefully controlled and is usually not a problem. However, sodium and potassium ions are present in most glasses. It is for this reason that the levels of sodium and potassium oxide are kept below 1% in glass cloth used for electrical applications (E-glass). The microspheres of the present invention contain neither potassium oxide nor sodium oxide.

In addition, since these microspheres are formed by the sol-gel method of the invention, the method to be described below, they are substantially free of alpha radiation, a form of natural radiation which is a common problem where naturally occurring materials are used and which interferes with the performance of the semiconductor chips. Therefore, they also can be used in semiconductor encapsulant applications. Alpha radiation is a product of the decomposition of radioactive isotopes such as uranium and thorium impurities. Impurities of this nature even on a part per billion level can produce alpha particle emission and as a result cause soft errors in memory chips.

Low coefficient of thermal expansion of a dielectric laminate is obtained by incorporating therein the low alpha emitting inorganic filler of the present invention. The purity of commercial grade tetraethoxysilane from which aerogel fillers are produced can be markedly increased by a single distillation. Table 3 shows the effect of distillation on the purity of ethyl silicate as reported by Gossink et al ("Ultrapure $Si0_2$ and $Al_20_3$ for the Preparation of Low Loss Compound Glasses" in Met. Res. Bull. 10(1975) 35).

Dielectric laminates are most commonly made by impregnating a roll of cloth material with a resin. This is done by dipping the cloth into a tank of resin and then drying and partially curing the resin with heat. Later the impregnated cloth, or prepreg, is cut up and press laminated or clad to copper foil, thus forming the laminate. The same process is used when microspheres are included by the process of the present invention. In this case a mixture of resin, and aerogel particulates dispersed in the resin is used. Since porous microspheres have a lower density than the resin/solvent mix, they normally tend to float. However because of the small size of the microspheres of the present invention, they have little buoyancy in relation to drag due to the liquid resin, and only minimal agitation, such as mixing with a rotating paddle agitator, is needed to keep them fully and uniformly suspended. The mixing may also be accomplished by ultrasonic agitation using a high power ultrasonic probe. A typical scanning electron micrograph of a composite resin having incorporated a high volume fraction of dispersed aerogel particulates is shown in Fig. 11.

The dielectric materials of the present invention must withstand very high lamination pressures without breaking. These laminates are made from a polymer resin having aerogel dispersed therein, by using flat bed press or autoclave lamination or extrusion. Dielectric sheets are sandwiched between two sheets of copper and laminated under heat and pressure. Typically $2.07 \times 10^6$ to about $1.38 \times 10^7$ Pa (about 300 to about 2000 PSI) pressure is used. One further important property a suitable microsphere filler must exhibit is the ability to withstand the pressure of this lamination process without breaking. It is suggested that suitable microspheres must exhibit no more than 10% volume loss due to breakage at isostatic pressures of $6.9 \times 10^6$ Pa (1000 PSI). The microspheres of the present invention can substantially withstand a far higher

pressure. Microsphere size is also important during lamination. Previous microsphere laminates suffered orientated warpage when heated. It is believed that when laminated in the horizontal position, the larger microspheres would migrate toward the top surface resulting in non-uniform distribution.

When sufficiently small sized microspheres are used as in the present invention, many problems previously experienced or anticipated will not occur. Benefits of very small microspheres include reduced buoyancy, uniform distribution, improved packing factor and enhanced electrical reliability.

In the present invention, the microspheres, being of extremely small diameter, remain uniformly distributed. A typical microstructure of an epoxy resin matrix composite having aerogel particulates as dispersed phase is shown in Figure 11. It is evident from the figure that the distribution of the spheres is quite uniform. Fig. 12 shows the distribution of commercial quartz powders, in the same weight fraction as aerogel particles, in an epoxy matrix.

The invention can be processed by known methods of vacuum lamination. A resin/microsphere precursor/carrier structure prepreg is prepared, B-stage cured, and then vacuum laminated. The impregnation mix is prepared by adding a predetermined quantity of microsphere precursor to the resin/solvent mixture sufficient to result in a packing factor of, for example, about 50% when the solvent is driven off and the sol-gel reaction is complete. The dielectric constant of the porous silica gel filler will be dictated by the volume fraction of the residual porosity. It is evident from the Tables 4 and 5 that the dielectric constants of the composites can be tailored by controlling the chemical composition of the aerogel, the volume fraction of the "hollowness", or voids, in the aerogel, and the nature of the polymer and volume of the aerogel having a particular void volume. Thus the approach of the present invention provides the flexibility to develop composites having values within a range of dielectric constants in either thin film or thick substrate form. It should be noted (See Table 3) that if the residual voids in $SiO_2$ comprise 40%, the dielectric constant will be between 2.2 and 2.8, based on the parallel mixing rule of calculating Er total as a weighted average of the Ers of the individual components. It should be emphasized that because of the extremely small pore diameter and the closing of pores after thermal treatment, the porosity can be maintained even after the formation within the organic polymer. Consequently, a composite comprising $SiO_2$ gel skeleton, within extremely small pores and polymer will be generated. The dielectric constant of the composite will be governed by: (a) the dielectric constant of the polymer, (b) the volume fraction of residual porosity, and (c) the dielectric constant of the gel, i.e. 3.8 for $SiO_2$. The dielectric constant of the glassy gel particulates is further reduced by incorporating boron oxide into the silica gel phase (D-Glass). The residual porosity and mechanical properties of the $Si0_2$ gel can be controlled by controlling the thermal history and the gel processing parameters in the manner described above. The sizes of the voids in the gel phase is in nanoscale. The sizes can be varied from about 2 nm to about 50 nm (about 20 Angstroms to about 500 Angstroms) as a function of the gel synthesis procedure and the thermal treatment after supercritical drying, as described above.

Figs 13 and 14 show the distribution of aerogel particulates and of conventional quartz particulates respectively in the same weight fraction in a photosensitive epoxy resin. Because of very low density of the aerogel particles, the volume fraction occupied by the aerogel microsphere is much higher. A typical calculation of the dielectric constant of porous silica gel as a function of volume of porosity is shown in Tables 4 and 5. The estimated dielectric constants of $SiO_2$ aerogel reinforced polymer components with varying volume fractions of aerogel microspheres having varying void contents are shown in Table 5. It is evident from the Table that even with as low as a 15% void content silica aerogel with a minimum 10% volume aerogel in the polymer having a dielectric constant 2.7 can make a composite laminate with a 2.74 dielectric constant. However, the void content in the aerogel can be easily kept in the range of about 5% to about 30% without significant deterioration of the mechanical properties of the aerogel. The aerogel particulates in our experiments were thermally treated in the temperature range of about 600 degrees C to about 1200 degrees C to reduce the porosity, to remove hydroxyl content and to collapse the interconnecting pores. The lower dielectric constant of the D-Glass, which is a borosilicate glass, is due to the presence of the $B_2O_3$ in the silica phase.

The combination of optimum microsphere size and packing factor of the present invention enables the filled dielectric material to withstand the heat and pressure cycle of lamination without undergoing breakage of the microporous microspheres. Because of the extremely fine size of the spheres and the absence of complete hollowness, the aerogel particulates are mechanically strong, particularly after partial densification.

The microspheres are treated with the silane-based coupling agent suitable for use with the specific resin. An especially suitable coupler for these formulations has been found to be about 0.5 to about 3% silane coupling agent for best moisture resistance and acceptable wet dielectric loss performance. Silane resin binds the filler particles within the resin matrix and minimizes the volume of the interfacial areas between the resin matrix and the microspheres.

The carrier/reinforcement material may be any known type of reinforcement such as glass or polytetrafluoroethylene (PTFE). The carrier fabric or film selected depends mostly on the properties desired for the finished laminate. These include thickness, Er, CTE, and the intended product application. Acceptable carrier materials include woven and non-woven fiber glass and polymer fabrics and mats. Organic films such as polyimide film can also be used. Low Er fabrics such as D-glass, aramids such as Kevlar and Nomex, both registered trademarks of E. I. Dupont de Nemours and Company, poly p-phenylene benzobisthiazole, poly p-phenylene benzobisoxazole, Polyetheretherketone, aromatic polyesters, quartz, S-glass, and the like, can also be used in the formulation. The reinforcement can be in a cowoven or comingled form. A typical microstructure of monodispersed $SiO_2$ gel particulates which could be used as the dispersed phase in the fabrication of particulate reinforced composites is shown in Figure 4. The pore diameter is in the range of about 1 nm to about 50 nm (about 10 Angstroms to about 500 Angstroms). A pore diameter in the 1 nm to 10 nm (10 Angstrom to 100 Angstrom) range is preferable.

Properties such as Er, Tg, water absorption, flammability, dielectric loss, melt viscosity, and gel time must all be considered in selecting the resin. In general, high temperature resistance and low dielectric constant are performed. One especially suitable epoxy resin from Ciba-Geigy Inc. is Ciba-Geigy Araldite 87-212. This resin has a bromine content of about 29%. Another suitable epoxy resin is Dow XU71825 marketed by Dow Chemical Company. Arocy F-40, a fluorinated dicyanate resin, marketed by Rhone-Poulenc, Inc. is also acceptable. Blends of epoxy and Arocy F-40 also appear to be acceptable. Resins such as Cyanates, Benzocyclobutenes, Fluoropolymers, (CTFE, PTFE, FEP, Teflon AF a trademark of E.I. DuPont de Nemours & Co., Inc., PFA), polyimides and the like, can also be used in the formulation.

The composite resin having various ratios of the resin/microsphere with various volume fractions of voids in the microsphere are used as the fabric prepreg materials in impregnating fabrics of various dielectric constants. A simple estimation of the Er of the fiber reinforced composite impregnated with the low dielectric constant composite resin can be made. The estimated values show that a fiber reinforced composite laminate having a dielectric constant 3.00 or even lower can be made with inorganic fabrics impregnated with a composite resin having a dielectric constant of 2.7. However, the prime advantage of this approach is the lowering of the CTE of the composite laminate as well as the dielectric constant. It should be noted also that the softening point, or Tg, of the final laminate will also be higher because the presence of the glassy filler incorporated into the polymer will increase the Tg of the polymer.

Preparation of Monosize Silica Gel Powders:

Monodispersed silica gel powders were prepared by the procedure originally developed by Stober et al. Tetraethoxysilane (TEOS) was hydrolyzed by a mixture of $NH_4OH$ and water in ethanol. A typical composition was 0.3 M to 0.5 M TEOS and .5 to 1.0 M $NH_3$ and 8.0 to 14 M $H_2O$. After the formation of dispersed particulates in ethanol, the solvent ethanol was removed by supercritical drying/extraction so that the voids generated during the polymerization process are maintained, and thus ultra high porosity particulates are produced. The gel particulates dispersed in ethanol solvent were dried by the supercritical drying technique. A brief description of the technique is given below: The gel powders dispersed in ethanol were placed in an autoclave and the drying was done under the supercritical condition of the solvent. The solvent is extracted at temperatures above the critical point Tc of the solvent at a critical pressure (Pc). At these conditions, solvent is removed without inducing capillary pressure and collapse of pores, due to interfacial tension. The first step was to apply an over pressure of Argon which is slightly higher than the critical pressure (Pc) of ethanol, by introducing Argon from an Argon cylinder. The pressure was increased to a pressure ranging from $8.27 \times 10^6$ to $8.96 \times 10^6$ Pa (1200 PSI to 1300 PSI). Once the pressure was reached, the temperature of the autoclave was increased slowly to a temperature above the critical point of ethanol in the range of about 250 degrees C to 260 degrees C; during this time the pressure was maintained in between $8.27 \times 10^6$ to $8.96 \times 10^6$ Pa (1200 PSI and 1300 PSI) by purging out Argon, if necessary. Once the temperature reached 250 degrees C, the temperature was allowed to remain constant. At this stage the fluid was purged by depressurizing and flushing with dry inert Argon. After the flushing out of the solvent, the system was cooled to room temperature. It should be noted that the capillary force during air drying can be expressed as

$$P = \frac{2 \nu \cos \theta}{r}$$

where $\nu$ is the interfacial tension of liquid, r is the capillary radius and $\theta$ is the wetting angle. Note that the capillary force could be as high as $10^6$ N/m$^2$ with the submicron scale pores when the wetting angle is zero

and the solvent is ethanol. Thus, the capillary pressure is high enough to collapse the pores or voids of very fine sizes. In other words, the stress increases without limit as r approaches zero value. During supercritical drying, however, this capillary pressure is almost non-existent because interfacial tension $\nu$ approaches zero. Consequently, the collapsing of the pores is insignificant or does not take place. As a result, a highly porous gel is obtained. Table 2 gives the pore volumes of aerogels and their densities.

Experiments have also been performed using silica aerogels as dispersed phase and Xydar from DARTCO Mfg., Inc., as a matrix phase. Xydar is a wholly aromatic thermoplastic polyester based on p-hydroxybenzoic acid, terephthalic acid, and bisphenol. Fine powdery resin was obtained by sifting Xydar XD-6 through a 50 mesh sieve.

As prepared silica aerogel particulates having a porosity of about 80% and a pore diameter of about 10 nm (about 100 Angstroms) were used as the dispersed phase after thermal treatment at 600 degrees C for 2 hours.

The volume fraction of porosity and the diameter of the hollow microspheres decreased to a certain extent after the thermal treatment, but were not measured. After being dried at 120 degrees C for 2 hours under vacuum, Xydar powder (15g) was blended with 5.0g of dried aerogel and filled in a 4 x 4 in mold with two pieces of 28.35 g (1 oz.) copper on each side. Lamination (molding) was carried out at 430 degrees C under nitrogen for 20 minutes. The resulting laminate, with thickness exhibited a dielectric constant of 2.46 at 1 GHz.

The resultant dielectric constant 2.46 was lower than the dielectric constant 2.72 of the Xydar itself, and also lower than the dielectric constant of dense silica glass, which is 3.8. The results indicate that the voids in the microspheres are maintained throughout processing and contribute to the lowering of the dielectric constant of the composite. It was noted that the presence of silica gel reduced the CTE of the composite; the presence of microspheres had no effect thereon. The CTE of the composite laminate was measured and was in the range of about 16 ppm to about 18 ppm.

The above process can be applied in making low dielectric, low CTE thin films for use as dielectric layers for high density packaging. The process has a general significance in tailoring the dielectric constants of dispersed phases, which could be inorganic or mixed inorganic-organic gels, and thus to tailor the dielectric constant of the composite of which it is a part. Commercially available fluoropolymer material, such as Rogers 2810, from Rogers Corporation, has a dispersed solid glassy phase of mixed size and a dielectric constant of 2.8.

The dispersed phase can be replaced in the present invention by aerogels of controlled size and tailorable dielectric constant. Moreover, the aerogel microspheres are of submicron size and dispersed in the resulting composite homogenously. The adhesion of the microspheres with the polymer will be acceptably good due the the high surface reactivity of submicron aerogel.

The role of the aerogel particulates is to produce an isotropic CTE, increase compressive strength of the dielectric, decrease dielectric constant, increase the toughness of the dielectric, and improve adhesion between the dispersed phase and the polymer matrix because of the high surface reactivity and the increase of total surface area due to the small sizes of the aerogel particulates.

Mixed inorganic/organic aerogels:

Silica gel doped with polydimethylsiloxane solution (PMDS) was used to reduce the brittleness of the glassy phase and to improve the adhesion of particulates to the matrix phase. The concentration of PDMS is from 2.5 to 5 grams per 100 grams of silica/inorganic silicate phase. This concentration is too low to significantly lower the CTE of the dispersed phase, but is high enough to lower the brittleness of the glassy gel phase. A typical synthesis procedure of the organically modified sol-gel is given below.

The silica sol doped with a small concentration of polydimethylsiloxane solution was prepared by mixing 2.5 g of polydimethylsiloxane solution (i.e., silanol terminated polydimethylsiloxane oligomers from Petrarch Systems, Inc.) in 100 g of silica in a silica sol, i.e., to silica sol comprising 100 g of silica in ethanol. The polydimethylsiloxane solution was added after the partial hydrolysis of tetraethoxysilane. The mixture was agitated for 1/2 hour to 1 hour before the precipitation of dispersed spherical particulates by following the procedure described in the section herein entitled, "Preparation of Monosize Silica Gel Powders".

The Si-OH terminated polydimethylsiloxane chains react with polymeric tetraethoxysilane molecules to give silica aerogels with improved toughness, primarily because of the presence of the flexible breakage of the organic chains between the silicate networks. A typical representation of mixed inorganic-organic gel is given below:

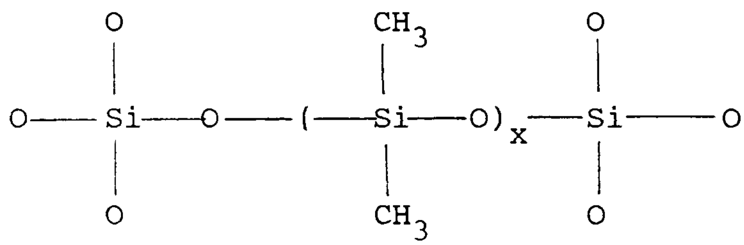

Inorganic Sol-Gel | Organic Linkage | Inorganic Sol-Gel

When the formulation and processing as described above are employed, a high quality, cost competitive, reliable, low Er microsphere laminate circuit board can be manufactured which exhibits low shrink warpage on processing, low dielectric constant, low dielectric loss tangent, acceptable dielectric breakdown voltage, acceptable adhesive strength, low CTE and low moisture absorption, and which passes solder shock testing. Photosensitive low dielectric thin film composite dielectric layers were also fabricated using a blend of photosensitive epoxy and aerogel particulates. 10-30% aerogel with an epoxy compound SU8 (from Hi-Tek, Inc.) and a cationic photoinitiator UVE-1014 available from GE were blended in methylisobutyl ketone 25 $\mu$m (one mil) thick film was prepared by solution coating. After 50 mJ/cm$^2$ exposure, development and cure at 150 degrees C, samples are shown in Fig. 13. To compare the superiority of the aerogel fillers, the patterns were developed using commercial quartz powders with the same proportions. Comparison of Figs. 13 and 14 shows the difference in the distribution and the adhesive behavior of two types of particulates in the matrix. It should be noted that because of the low density of the aerogel a high volume fraction of aerogel can be introduced, although the weight fraction is the same as that of dense quartz powder. The particles are well distributed and show no debonding, which is pronounced with the commercial quartz powders (see Figs. 13 and 7).

**Claims**

**1.** A filled dielectric material having a dielectric constant below 3.0, comprising at least one polymer resin and a filler of molecular dimension.

**2.** The material recited in claim 1, wherein the polymer resin is selected from the group consisting of cyanate, epoxy, benzocyclobutane, polyimide, fluoropolymer and fluorinated dicyanate.

**3.** The material of claim 1 or 2, wherein the filler comprises an aerogel filler.

**4.** The material recited in anyone of claims 1 to 3, wherein the filler comprises microporous aerogel inorganic or mixed organic/inorganic microsphere fillers having less than 1 $\mu$m diameter.

**5.** The material recited in claim 4, wherein the microporous aerogel inorganic or mixed organic/inorganic microspheres of the filler are randomly distributed and exhibit a compressive strength of between about $3.45 \times 10^6$ to about $3.45 \times 10^7$ Pa (about 500 to about 5000 pounds per square inch).

**6.** The material recited in claim 1, comprising also a reinforcement material.

**7.** The material recited in claim 6, wherein the reinforcement material comprises a woven cloth, mat or film selected from the group consisting of glass, ceramic, fluoropolymer, polyester, quartz, polyimide, Kevlar®, Nomex®, poly p-phenylene benzobisthiazole, poly p-phenylene benzobisoxazole, Aramid, polyetheretherketone, and aromatic polyester.

**8.** The material recited in anyone of the preceding claims, wherein the polymer resin and aerogel inorganic microsphere filler comprise a flame retardant material.

**9.** The material recited in anyone of the preceding claims, wherein the aerogel microspheres of the filler

are glass or silica walled and have a mean diameter from about 1 nm to about 1000 nm (about 10 Angstroms to about 10,000 Angstroms), and include voids having a maximum diameter of less than about 10 nm (100 Angstroms).

**10.** The material recited in claim 9 wherein the aerogel microspheres of the filler comprise from about 25 to about 65 percent by volume.

**11.** A printed circuit board comprising a filled dielectric material having a dielectric constant below 3.0, which material includes at least one polymer resin and aerogel inorganic or mixed organic/inorganic microsphere filler of molecular dimension; the circuit board also including at least one layer of conductive material disposed on at least a portion thereof, and optionally a reinforcement material.

**12.** A method of making a printed circuit board including a filled dielectric material having a dielectric constant less than 3.0, comprising:

a) making a mixture of polymer resin and aerogel microspheres;
b) impregnating a reinforcement material with the mixture to form a prepreg material;
c) partially curing the impregnated reinforcement material;
d) cladding the partially cured impregnated reinforcement material with at least one layer of metal; and
e) laminating together a plurality of layers of metal clad impregnated reinforcement material under heat and pressure.

**13.** The method recited in claim 12, including in addition the step of drilling at least one through hole.

**14.** A method of making a printed circuit board including a filled dielectric material having a dielectric constant less than 3.0, comprising:

a) making a mixture of polymer resin and aerogel microspheres, either by solution mixing or melt blending and extrusion;
b) cladding the extruded mixture with a layer of metal; and
c) laminating together under heat and pressure a plurality of layers of the metal clad extruded mixture.

**15.** A method of making a circuit pattern on an electronic substrate comprising:

applying to a substrate a layer of photosensitized polymer resin material which includes microporous inorganic or mixed inorganic/organic aerogel microsphere filler having less than 1 µm diameter;
at least partially curing the resin material and exposing and developing a circuit pattern in the at least partially cured resin material photolithographically; and
plating metal on the substrate to build up the circuit pattern.

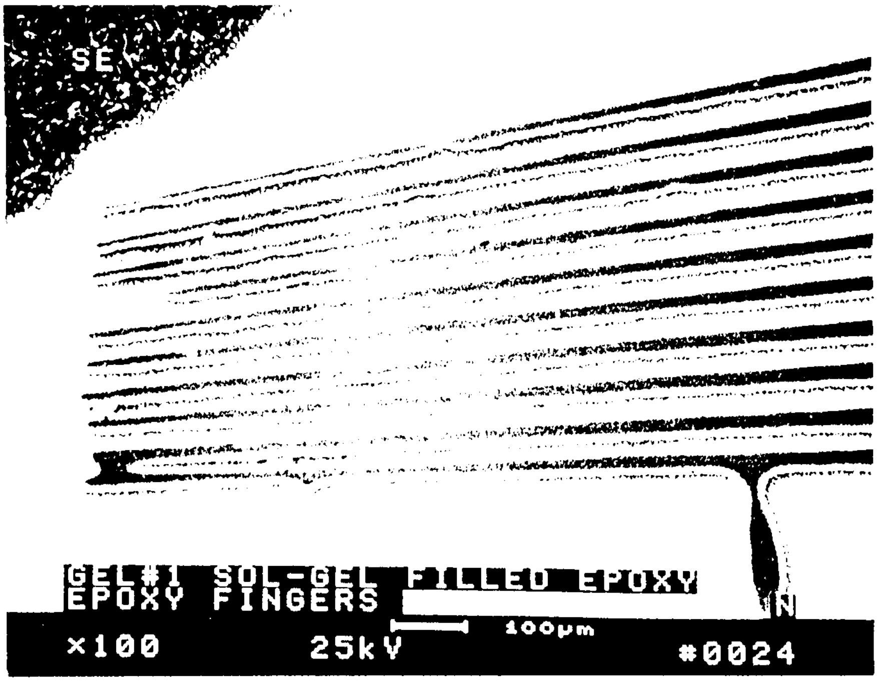
SE
GEL#1 SOL-GEL FILLED EPOXY
EPOXY FINGERS
N
×100 25kV 100μm #0024

FIG. 1a

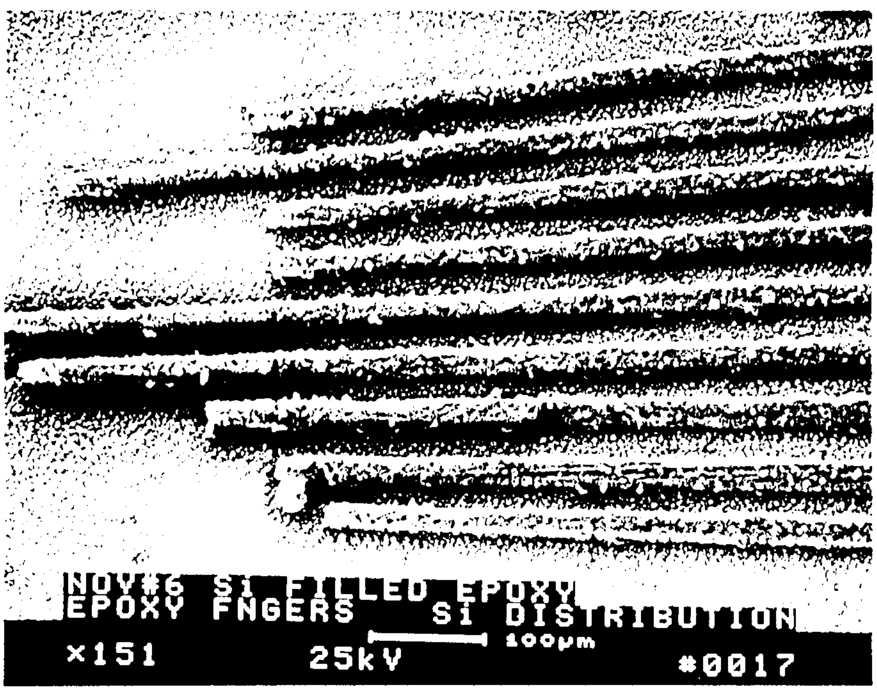
NOV#6 SI FILLED EPOXY
EPOXY FNGERS SI DISTRIBUTION
×151 25kV 100μm #0017

FIG. 1b

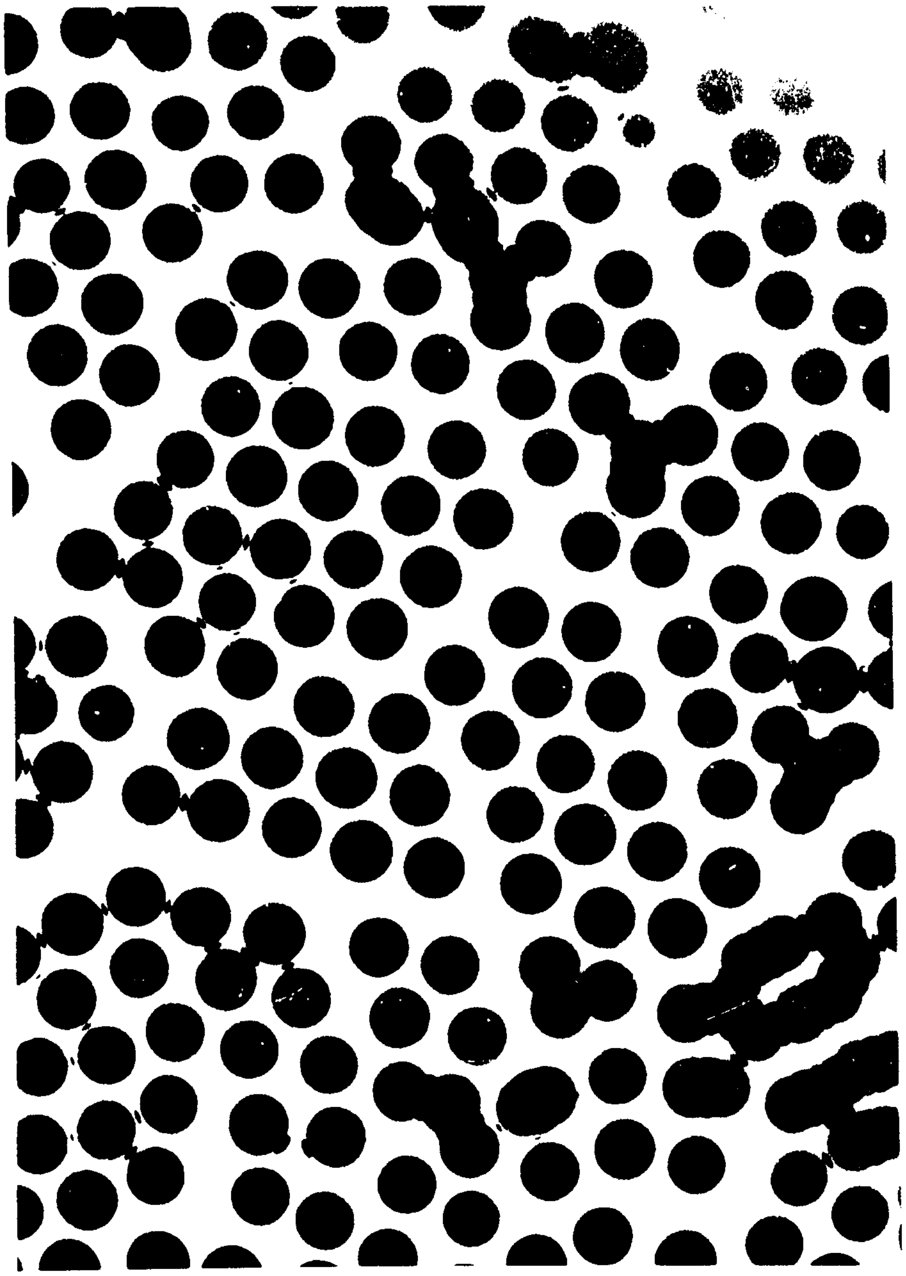

FIG. 2

FIG. 3

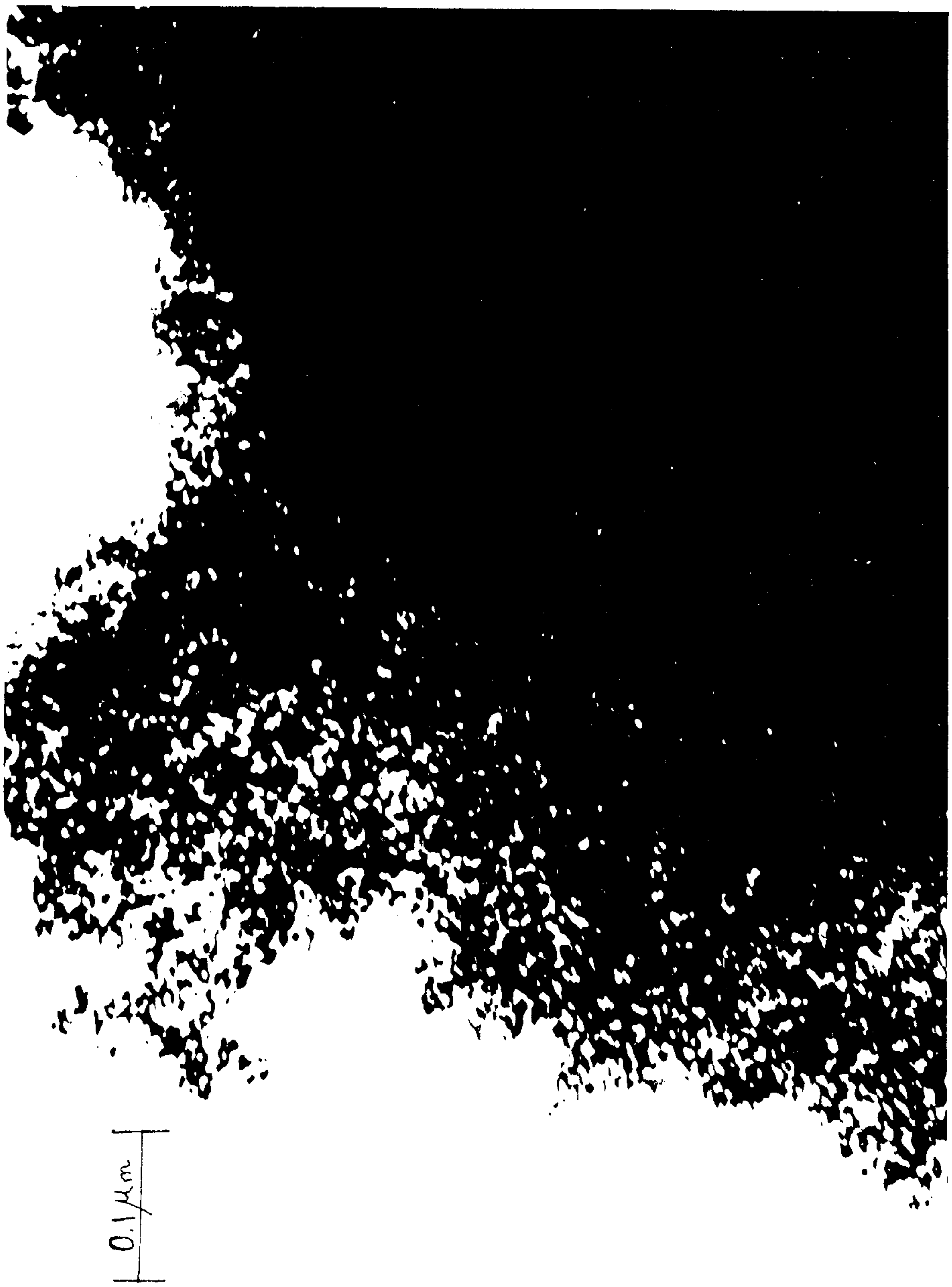

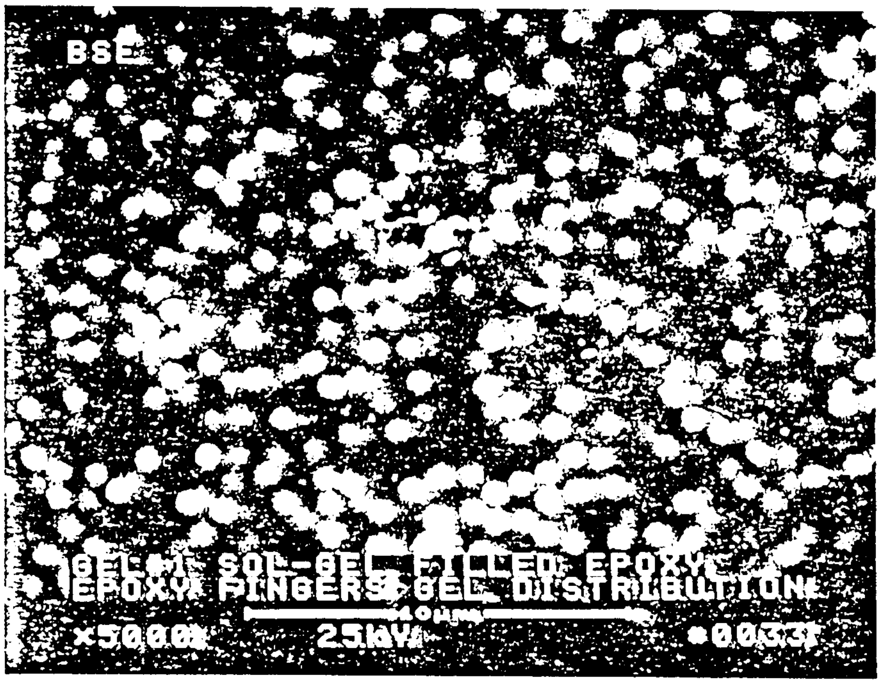
BSE
GEL#1 SOL-GEL FILLED EPOXY
EPOXY FINGERS GEL DISTRIBUTION
x5000 25kV #0033
10μm

FIG. 4

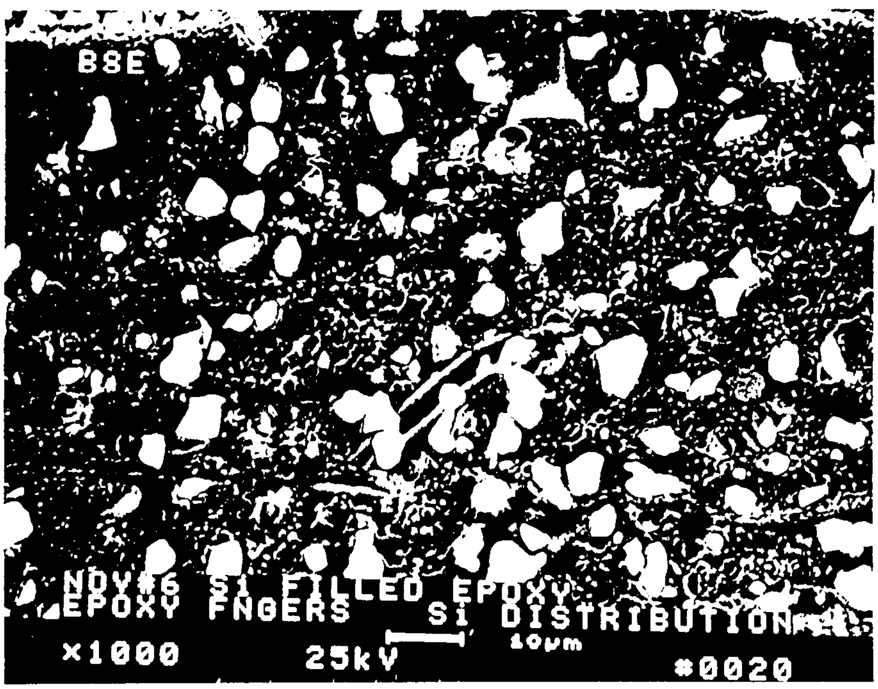
BSE
NDV#6 Si FILLED EPOXY
EPOXY FNGERS Si DISTRIBUTION
x1000 25kV #0020
10μm

FIG. 5

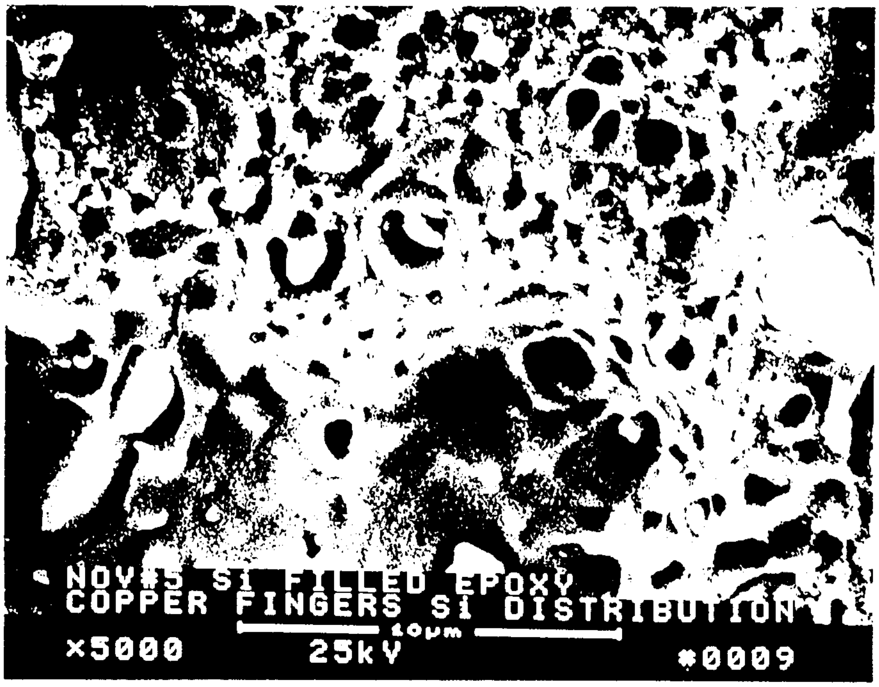
NOV#5 SI FILLED EPOXY
COPPER FINGERS SI DISTRIBUTION
10μm
×5000
25kV
#0009

FIG. 6

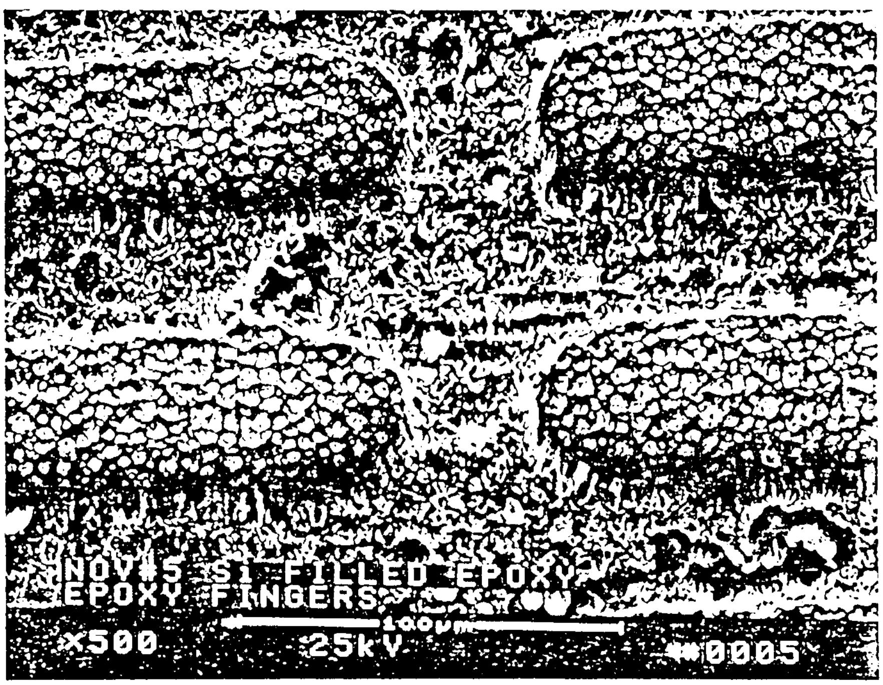
NOV#5 SI FILLED EPOXY
EPOXY FINGERS
100μm
×500
25kV
#0005

FIG. 7

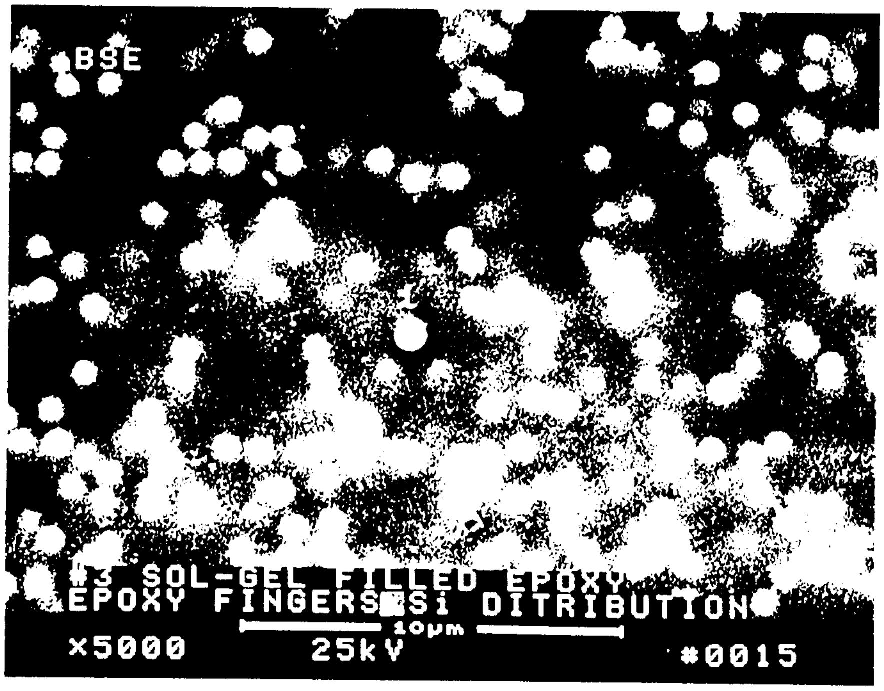
BSE
#3 SOL-GEL FILLED EPOXY
EPOXY FINGERS Si DITRIBUTION
10μm
×5000
25kV
#0015

FIG. 8

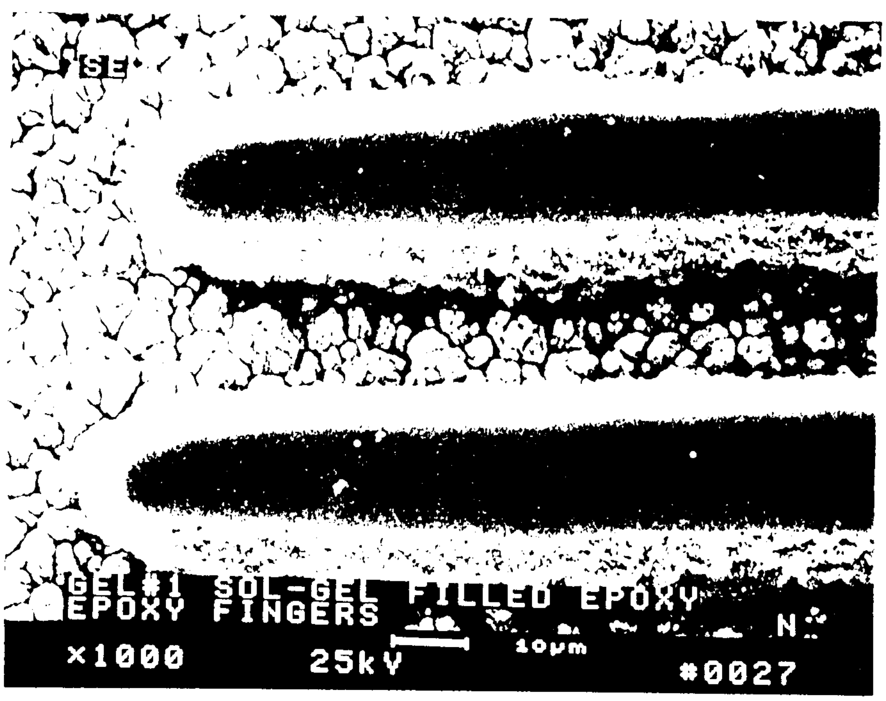
BSE
GEL#1 SOL-GEL FILLED EPOXY
EPOXY FINGERS
10μm
×1000
25kV
#0027

FIG. 9

FIG.10

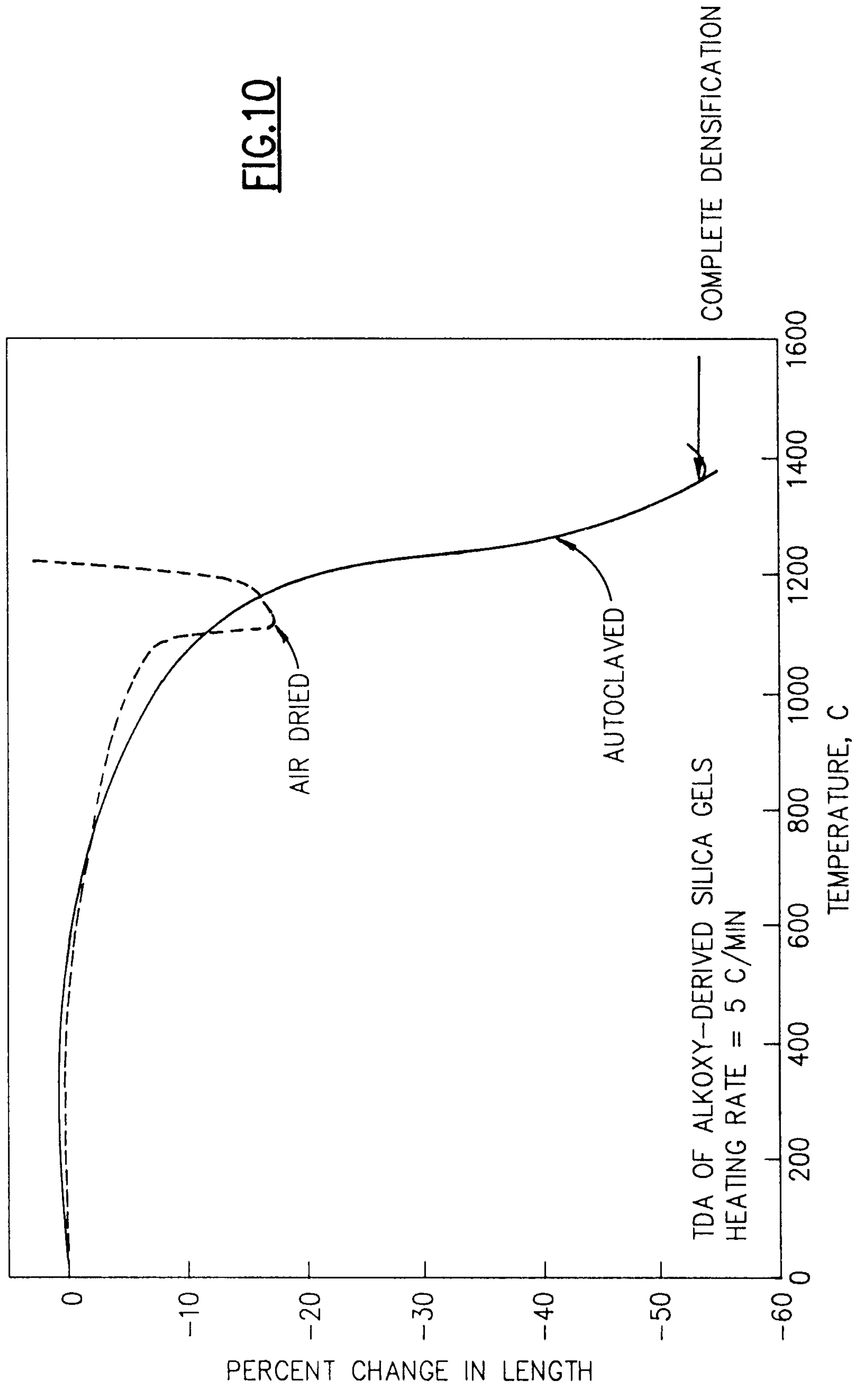
COMPLETE DENSIFICATION
AIR DRIED
AUTOCLAVED
TDA OF ALKOXY-DERIVED SILICA GELS
HEATING RATE = 5 C/MIN
TEMPERATURE, C
0
200
400
600
800
1000
1200
1400
1600
PERCENT CHANGE IN LENGTH
0
-10
-20
-30
-40
-50
-60

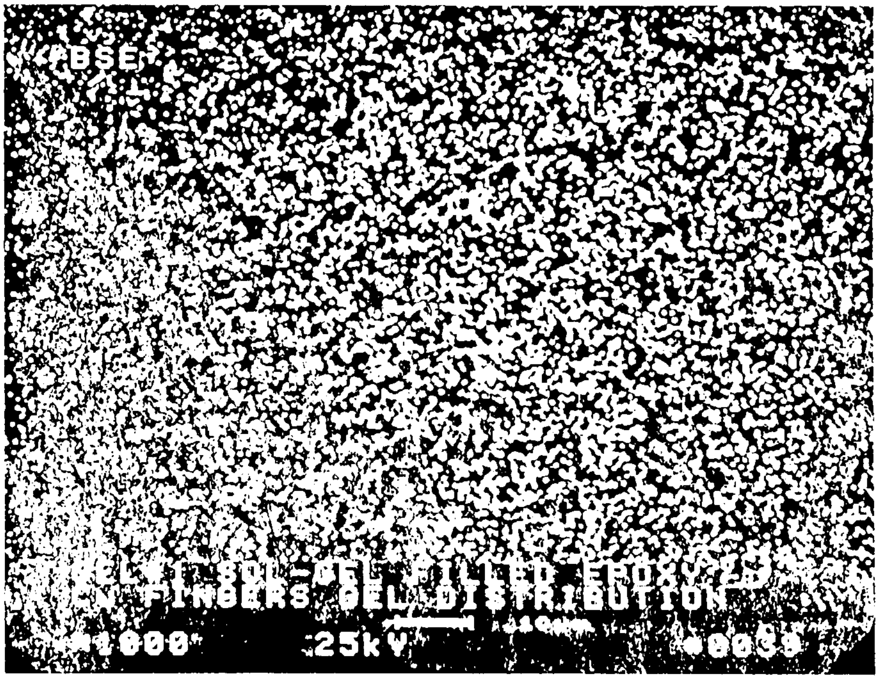
BSE
FINGERS
DISTRIBUTION
25kV

FIG. 11

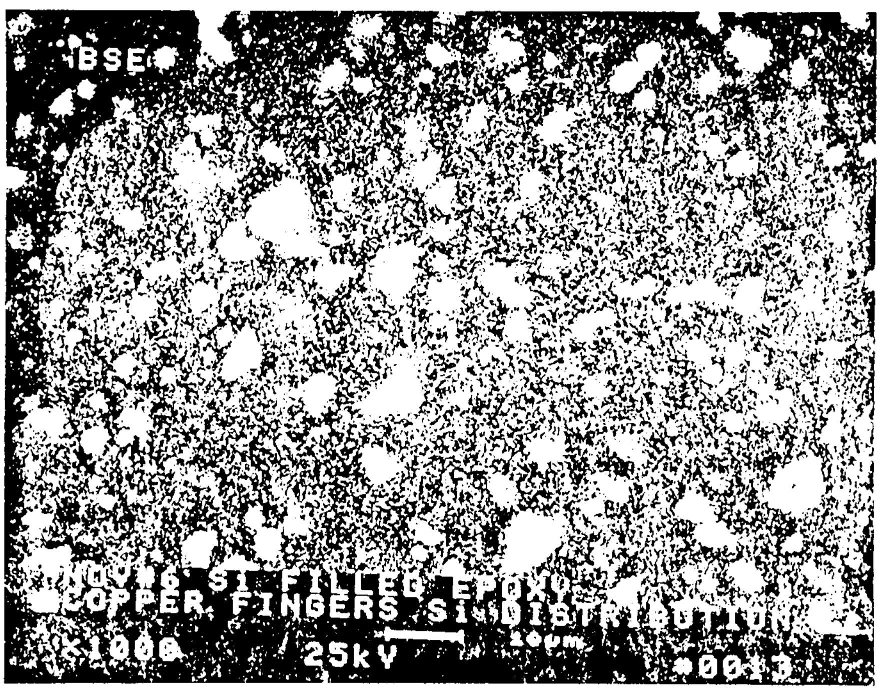
BSE
FILLED EPOXY
COPPER FINGERS SI DISTRIBUTION
25kV

FIG. 12

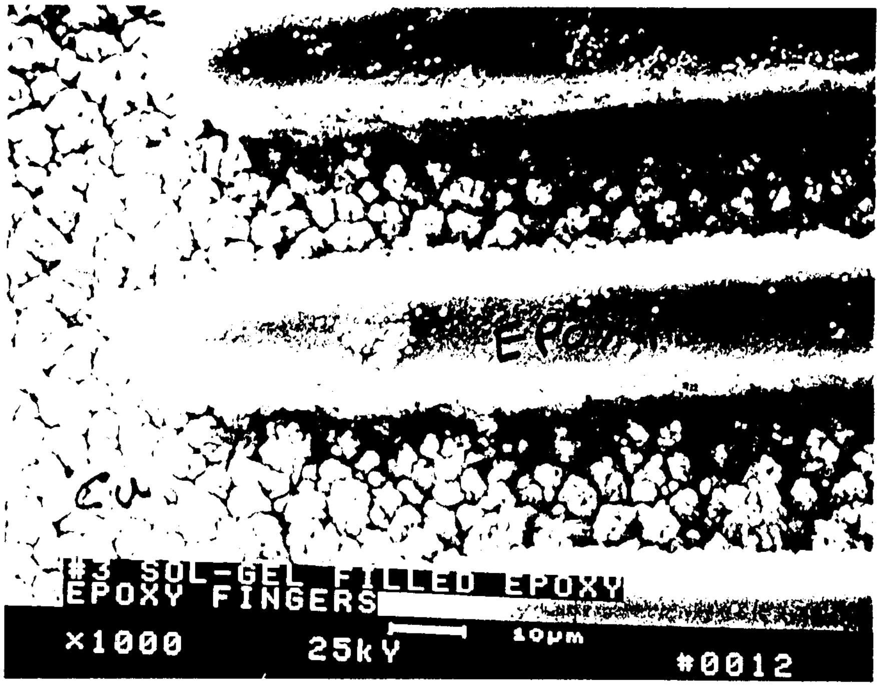
Epoxy
Cu
#3 SOL-GEL FILLED EPOXY
EPOXY FINGERS
×1000
25kV
10μm
#0012

FIG. 13

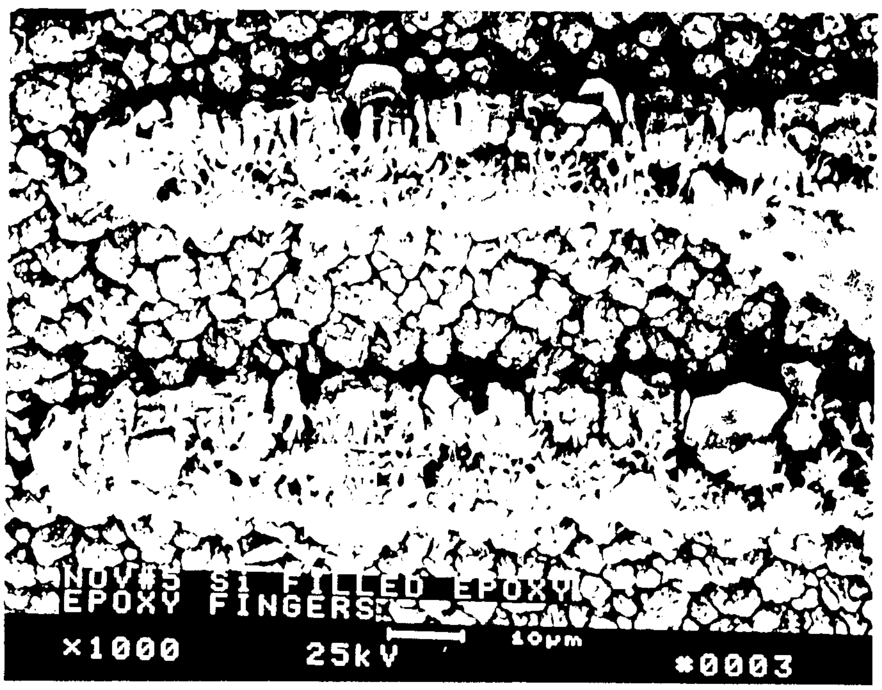
NOV#5 SI FILLED EPOXY
EPOXY FINGERS
×1000
25kV
10μm
#0003

FIG. 14

## TABLE 1

DIELECTRIC CONSTANTS OF THERMOPLASTICS

| POLYMER | DIELECTRIC CONSTANT (E) |
|---|---|
| EPOXY | 3.6 |
| POLYETHYLENE | 2.3 |
| POLYPROPYLENE | 2.3 |
| POLYIMICES | 3.1 TO 3.8 |
| POLYTETRAFLUROETHYLENE (PTFE) | 2.1 |
| XYDAR® (AMOCO CHEM. CO.) | 2.7 |
| FLUORINATED POLYMIDE | 2.4 TO 2.9 |
| PEEK | 3.3 |
| TORLON® (AMOCO CHEM. CO.) | 3.5 |
| BISPHENOL A CYANATE | 2.8 TO 3.0 |
| AROCY F-40 (RHONE-POULENC) | 2.65 |
| VECTRA® (HOECHST-CELANESE) | 2.7-3.2 |

## TABLE 2

PHYSICAL PROPERTIES OF $SiO_2$ AEROGEL

| DENSITY P(g/cm$^3$) | POROSITY VOL. FRACTION | DIELECTRIC CONSTANT E |
|---|---|---|
| 0.065 | 0.972 | – |
| 0.11 | 0.953 | – |
| 0.141 | 0.37 | – |
| 0.156 | 0.930 | 1.14 (AT 1 MHz) |

## TABLE 3

EFFECT OF DISTILLATION ON THE PURITY OF ETHYL SILICATE

| ppb | Cr | Mn | Fe | Co | Ni | Cu |
|---|---|---|---|---|---|---|
| STARTING PRODUCT | 15 | 10 | 86 | 0.74 | 200 | 200 |
| ONCE DISTILLED | 2.2 | 0.79 | 31 | 0.3 | 11 | 20 |
| RESIDUE | 140 | 87 | 1000 | 1.1 | 400 | 1000 |

## TABLE 5

ESTIMATED DIELECTRIC CONSTANTS OF $SIO_2$ AEROGEL REINFORCED COMPOSITES

VOL. FRACTION

| POLYMER (V1) | GEL-GLASS (V2) | ∈1 POLYMER | ∈2 (GEL-GLASS) | $\in^1$ |
|---|---|---|---|---|
| 90 | 10 | 2.7 | 3.13 (15% VOID) | 2.74 |
| 90 | 10 | 2.1 | 3.13 | 2.18 |
| 80 | 20 | 2.1 | 3.13 | 2.27 |
| 80 | 20 | 2.1 | 3.55 (5%VOID) | 2.33 |
| 95 | 5 | 2.8 | 2.72 (25% VOID) | 2.70 |

## TABLE 4

ESTIMATED DIELECTRIC CONSTANTS OF $SIO_2$ AEROGEL AS FUNCTION OF VOLUME FRACTION OF VOIDS

$$L_n \in^1 = {}_1V \ l_n \in_1 + {}_2V \ l_n \in_2$$

VOL. FRACTION

| SIO2 (V1) | VOIDS (V2) | ∈1 | ∈2 | $\in^1$ RESULTANT |
|---|---|---|---|---|
| 95 | 5 | 3.8 | 1 | 3.55 |
| 90 | 10 | 3.8 | 1 | 3.32 |
| 85 | 15 | 3.8 | 1 | 3.13 |
| 80 | 20 | 3.8 | 1 | 2.90 |
| 75 | 25 | 3.8 | 1 | 2.72 |
| 70 | 30 | 3.8 | 1 | 2.54 |
| 60 | 40 | 3.8 | 1 | 2.22 |
| – | – | – | – | – |
| | D-GLASS | | | |
| 90 | 10 | 3.56 | 1 | 3.13 |
| 80 | 20 | 3.56 | 1 | 2.76 |